Europäisches Patentamt

(19) European Patent Office    (11) Publication number: **0 106 467**

Office européen des brevets    **B1**

(12) **EUROPEAN PATENT SPECIFICATION**

(45) Date of publication of patent specification: **30.07.86**    (51) Int. Cl.⁴: **G 01 R 1/04, G 12 B 9/08**

(21) Application number: **83304996.8**

(22) Date of filing: **30.08.83**

(54) **An Electrical measuring instrument.**

(30) Priority: **15.10.82 GB 8229563**

(43) Date of publication of application:
**25.04.84 Bulletin 84/17**

(45) Publication of the grant of the patent:
**30.07.86 Bulletin 86/31**

(84) Designated Contracting States:
**DE FR GB NL**

(56) References cited:
**FR-A-2 188 908**
**US-A-4 176 315**

(73) Proprietor: **THORN EMI Instruments Limited**
**Avocet House Archcliffe Road**
**Dover Kent, CT17 9EN (GB)**

(72) Inventor: **Tedd, David Clifford**
**6 Godwyn Gardens**
**Folkestone Kent (GB)**
Inventor: **Friend, Terence Michael**
**Meadowside The Street**
**Guston Nr. Dover Kent (GB)**
Inventor: **Nichols, Peter George**
**1, Downside Road**
**Whitfield Dover (GB)**

(74) Representative: **Marsh, Robin Geoffrey et al**
**Thorn EMI Patents Limited The Quadrangle**
**Westmount Centre Uxbridge Road**
**Hayes Middlesex, UB4 0HB (GB)**

Courier Press, Leamington Spa, England.

## Description

This invention relates to an electrical measuring instrument.

An electrical measuring instrument is usually provided with electrical leads having either removable crocodile clips or probes on the ends thereof enabling an electrical connection to be made between the instrument and electrical components under test.

Hitherto, storage of the leads when the instrument is not being used, has presented a problem. US 4,176,315 describes an instrument having a separate compartment in which the leads can be stored when the instrument is not in use. However, this arrangement tends to be wasteful of space. FR 2,188,908 describes an instrument including a handle around which the leads may be wound. The arrangement may also be somewhat unsatisfactory as the leads make the instrument difficult to carry and can slip off the handle. In other instruments the leads must be detached and carried separately, and this tends to reduce the portability of such instruments.

It is therefore an object of the present invention to provide a substantially improved electrical measuring instrument.

According to the invention there is provided an electrical measuring instrument including carrying means by which the instrument may be carried, said carrying means comprising first and second handle portions spaced apart from each other so as to provide a gap through which electrical lead attachments for said instrument may be accommodated.

According to a further feature of the invention there is provided an electrical measuring instrument having a casing provided with storage means for storing attachments for said instrument.

The invention will now be further described by way of example only with reference to the accompanying drawings, wherein:

Figure 1 shows a front view of a preferred embodiment of the invention, and,

Figure 2 shows a perspective rear view of the embodiment.

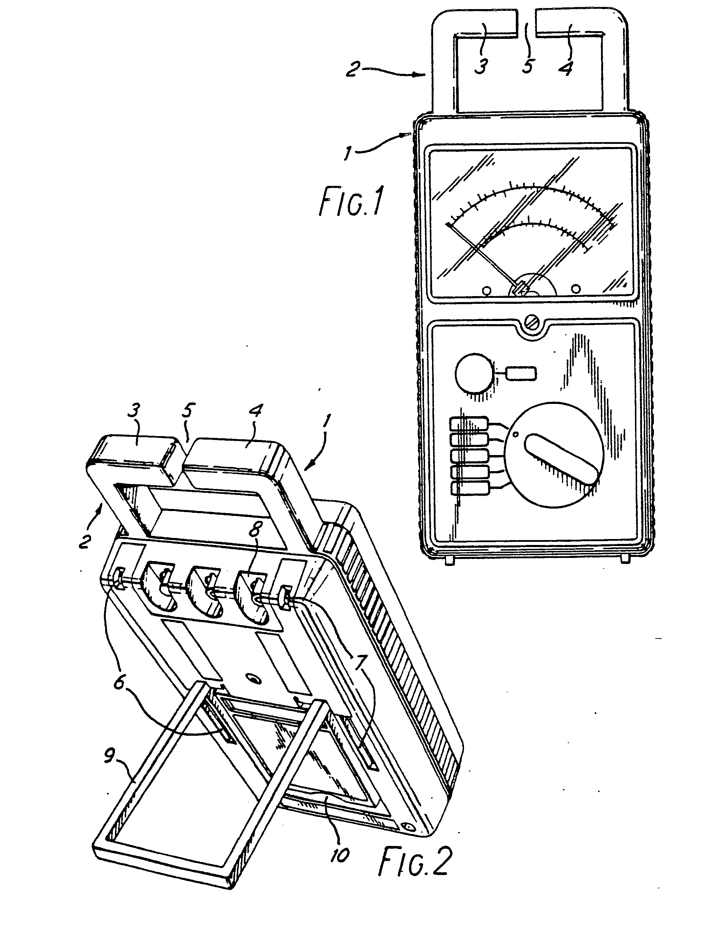

Figure 1 shows an electrical measuring instrument having a casing 1 and a handle 2 consisting of two portions, 3 and 4, spaced apart to form a gap 5.

Each handle portion, 3 and 4, comprises two parts, a first part extending vertically and a second part extending horizontally, the end faces of each second part being in close proximity to each other, so as to define the gap 5.

The handle portions, 3 and 4, are preferably co-planar with each other, so that the end faces are parallel to each other.

Additionally, the handle portions are preferably disposed in the vertical plane of the instrument.

Figure 2 shows a rear view of the instrument shown in Figure 1 and also shows, in addition to the spaced-apart handle portions, 3 and 4, storage wells, 6 and 7, incorporated in the casing 1 of the instrument.

Electrical sockets, one being shown at 8, are also located on the rear of the casing 1, in close proximity to the handle portions 3 and 4.

Electrical leads (not shown) can be inserted into the sockets 8 so that electrical connection can be made between the instrument and an electrical component, which is required to be measured.

The ends of the electrical leads may be provided with such attachments as, for example, crocodile clips or probes to provide electrical contact with the component.

When the instrument is required to be carried, the leads connected to the sockets 8 may be inserted through the gap 5 and wound longitudinally around the complete instrument and they are held secure by the handle portions, 3 and 4.

The storage wells, 6 and 7, can be used to store spare attachments which are not attached to the ends of the leads.

Consequently, for example, if the leads have crocodile clips attached thereto, then the probes may be inserted into the wells, 6 and 7, and stored until they are required to be used.

Conversely, the tubular ends of the crocodile clips may be inserted into wells, 6 and 7, whilst the probes are attached to the ends of the leads.

It can therefore be envisaged that the present invention provides a substantially more compact, and thus more portable, electrical measuring instrument than has been provided heretofore.

The instrument may also be provided with a hinged stand arrangement 9, which can easily be accommodated into grooves 10 of the casing 1, when the instrument is being carried.

## Claims

1. An electrical measuring instrument including carrying means (2) by which the instrument may be carried, characterised in that said carrying means (2) comprises first and second handle portions (3,4) spaced apart from each other so as to provide a gap (5) through which electrical lead attachments for said instrument may be accommodated.

2. An electrical measuring instrument as claimed in claim 1 wherein electrical sockets (8) are provided on said instrument, in close proximity to said handle portions (3,4), thereby enabling electrical lead attachments connected to said sockets (8) to be wound longitudinally around said instrument and to be retained therearound by said handle portions (3,4).

3. An electrical measuring instrument as claimed in claim 1 or 2 wherein each of said handle portions (3,4) consists of a first part extending generally vertically and a second part extending generally horizontally, so that end faces of said second parts are situated in close proximity to each other, so as to define said gap (5).

4. An electrical measuring instrument as claimed in claim 3 wherein said handle portions (3,4) are co-planar so that said end faces are substantially parallel to each other.

5. An electrical measuring instrument as claimed in any preceding claim wherein said handle portions are co-planar with a vertical plane of said instrument.

6. An electrical measuring instrument as claimed in any preceding claim, and having a casing (1) provided with storage means (6,7) for storing attachments for said instrument.

7. An electrical measuring instrument as claimed in claim 6 wherein said storage means (6,7) consists of wells (6,7) formed in said casing (1).

8. An electrical measuring instrument as claimed in claim 6 or 7 wherein said attachments include probes and/or crocodile clips for attachment to an end of an electrical lead.

9. An electrical measuring instrument as claimed in any preceding claim wherein a hinged stand arrangement (9) is provided for said instrument at the rear thereof.

10. An electrical measuring instrument as claimed in claim 9 wherein a groove (10) is formed in a rear side of said instrument for accommodating said stand arrangement (9) when not in use.

**Patentansprüche**

1. Eletrisches Meßinstrument, das Tragemittel (2) enthält, mit denen das Instrument getragen werden kann, dadurch gekennzeichnet, daß die genannten Tragemittel (2) erste und zweite Hangriffteile (3, 4) aufweisen, die einem Abstand voneinander haben und dadurch einen Spalt (5) bilden, durch den hindurch elektrisches Leitungszubehör für das Instrument aufgenommen werden kann.

2. Elektrisches Meßinstrument nach Anspruch 1, bei dem in dichter Nähe zu den genannten Handgriffteilen (3, 4) elektrische Buchsen (8) vorgesehen sind, wodurch elektrisches Leitungszubehör, das an die genannten Buchsen (8) angeschlossen ist, in Längsrichtung um das Instrument gewickelt und durch die genannten Handgriffteile (3, 4) darum gehalgten werden kann.

3. Elektrisches Meßinstrument nach Anspruch 1 oder 2, bei dem jeder der Handgriffteile (3, 4) aus einem ersten, sich im allgemeinen vertikal erstreckenden Teil und aus einem zweiten, sich im allgemeinen horizontal erstreckenden Teil besteht, so daß sich die Endfächen der genannten zweiten Teile in dichter Nachbarschaft zueinander befinden und dadurch den genannten Spalt (5) bilden.

4. Elektrisches Meßinstrument nach Anspruch 3, bei dem die genannten Handgriffteile (3, 4) koplanar sind, so daß die genannten Enflächen im wesentlichen parallel zueinander sind.

5. Elektrisches Meßinstrument nach einem der vorhergehenden Ansprüche, bei dem die genannten Handgriffteile koplanar mit einer vertikalen Ebene des Instruments sind.

6. Elektrisches Meßinstrument nach einem der vorhergehenden Ansprüche, das ein Gehäuse (1) besitzt, das mit Speichermitteln (6, 7) zur Aufbewahrung von Zubehör für das Instrument versehen ist.

7. Elektrisches Meßinstrument nach Anspruch 6, bei dem die genannten Speichermittel (6, 7) aus in das Gehäuse (1) eingelassenen Hohlräumen (6, 7) bestehen.

8. Elektrisches Meßinstrument nach Anspruch 6 oder 7, bei dem das Zubehör Taster und/oder Krokodilklemmen zur Anbringung an einem Ende einer elektrischen Leitung enthält.

9. Elektrisches Meßinstrument nach einem der vorhergehenden Ansprüche, bei dem an der Rückseite des Instruments klappbar eine Standvorrichtung (9) für dieses vorgesehen ist.

10. Elektrisches Meßinstrument nach Anspruch 9, bei dem in einer Rückseite des genannten Instruments eine Rille (10) zur Aufnahme der genannten Standvorrichtung (9) bei Nichtgebrauch vorgesehen ist.

**Revendications**

1. Instrument de mesure électrique comprenant des moyens de support (2) à l'aide desquels l'instrument peut être portè, caractérisé en ce que les moyens de support (2) comprennent un premier et un second éléments de poignée (3,4) écartés l'un de l'autre de manière à ménager un interstice (5) à travers lequel on peut faire passer des organes de raccordement de fils électriques pour ledit instrument.

2. Instrument de mesure électrique selon la revendication 1, dans lequel des prises électriques (8) sont prévues sur ledit instrument, à proximité directe desdits éléments de poignée (3,4), ce qui permet d'enrouler lesdits organes de raccordement des fils électriques reliés auxdites prises (8) longitudinalement autour dudit instrument et qui'ils soient retenus autour de ce dernier au moyen desdits éléments de poignée (3,4).

3. Instrument de mesure électrique selon la revendication 1 ou 2, dans lequel chacun desdits éléments de poignée (3,4) comporte une première partie s'étendant d'une manière générale verticalement, et une seconde partie s'étendant d'une manière générale horizontalement, de sorte que les faces d'extrémité desdites secondes parties sont situées à proximité directe l'une de l'autre, de manière à définir ledit interstice (105).

4. Instrument de mesure électrique selon la revendication 3, dans lequel desdits éléments de poignée (3,4) sont coplanaires de sorte que lesdites faces d'extrémité sont essentiellement parallèles entre elles.

5. Instrument de mesure électrique selon l'une quelconque des revendications précédentes, dans lequel lesdits éléments de poignée sont coplanaires avec un plan vertical dudit instrument.

6. Instrument de mesure électrique selon l'une quelconque des revendications précédentes, comportant un boîtier (1) muni de moyens de rangement (6,7) servant au rangement des organes de raccordement prévus pour ledit instrument.

7. Instrument de mesure électrique selon la revendication 6, dans lequel desdits moyens de rangement (6,7) sont constitués par des cavités (6,7) ménagées dans ledit boîtier (1).

8. Instrument de mesure électrique selon la revendication 6 ou 7, dans lequel lesdits organes de raccordement comprennent des sondes et/ou des pinces crocodile destinées à être raccordées à une extrémité d'un fil électrique.

9. Instrument de mesure électrique selon l'une quelconque des revendications précédentes, dans lequel un système (9) formant support articulé est prévu pour ledit instrument, sur l'arrière de ce dernier.

10. Instrument de mesure selon la revendication 9, dans lequel une rainure (10) est ménagée dans une face arrière dudit instrument de manière à loger ledit système formant support (9) lorsqu'il n'est pas utilisé.

FIG.1

FIG.2